(19)

Europäisches
Patentamt
European
Patent Office
Office européen
des brevets

(11) **EP 1 712 877 B1**

(12) **EUROPEAN PATENT SPECIFICATION**

(45) Date of publication and mention
of the grant of the patent:
**11.11.2009 Bulletin 2009/46**

(51) Int Cl.:
***G01B 21/08*** (2006.01)     ***G01C 3/00*** (2006.01)

(21) Application number: **06007321.0**

(22) Date of filing: **06.04.2006**

(54) **Distance estimation apparatus, abnormality detection apparatus, temperature regulator and thermal treatment apparatus**

Vorrichtung zur Schätzung von Entfernungen, Fehlererkennungvorrichtung, Temperaturregler und Wärmebehandlungsvorrichtung

Dispositif d'estimation de distances, dispositif de détection d'anomalies, regulateur de temperature et dispositif de traitement thermique

(84) Designated Contracting States:
**DE FR GB IT**

(30) Priority: **11.04.2005 JP 2005113306**

(43) Date of publication of application:
**18.10.2006 Bulletin 2006/42**

(73) Proprietor: **OMRON CORPORATION**
**Kyoto-shi, Kyoto 600-8530 (JP)**

(72) Inventors:
• **Yamada, Takaaki,**
**Omron Corp.**
**Shimogyo-ku**
**Kyoto-shi**
**Kyoto 600-8530 (JP)**
• **Nanno, Ikuo,**
**Omron Corp.**
**Shimogyo-ku**
**Kyoto-shi**
**Kyoto 600-8530 (JP)**

• **Ozaki, Fuminori,**
**Omron Corp.**
**Shimogyo-ku**
**Kyoto-shi**
**Kyoto 600-8530 (JP)**

(74) Representative: **Kilian, Helmut**
**Wilhelms, Kilian & Partner**
**Patentanwälte**
**Eduard-Schmid-Strasse 2**
**81541 München (DE)**

(56) References cited:
**AT-B- 406 423     DE-A1- 4 305 498**

• **PATENT ABSTRACTS OF JAPAN vol. 017, no. 014 (P-1467), 11 January 1993 (1993-01-11) & JP 04 242105 A (SUMITOMO METAL IND LTD), 28 August 1992 (1992-08-28)**

**Description**

BACKGROUND OF THE INVENTION

1. Field of the invention

The present invention relates to a distance estimation apparatus for estimating a distance between an object to be treated and a thermal treatment means in thermal treatment such as heating treatment and cooling treatment, and an abnormality detection apparatus, a temperature regulator and a thermal treatment apparatus, for which the distance estimation apparatus is used.

2. Description of the related art

Conventionally, for example in a manufacturing process for a semiconductor apparatus, a work such as a glass substrate is placed with respect to a hot plate having been heated to a set temperature, and then thermally treated for a predetermined period of time (e.g. Japanese Patent Application Laid-Open No. 2004-134723).
In such thermal treatment, for example in a case where a foreign substance or the like intervenes between the work and the hot plate or the work has been transformed, namely, in a case where a distance between the work and the hot plate is not normal, thermal treatment becomes incomplete, which might lead to generation of a large number of defective products incompletely thermally treated in such a manufacturing process as a process for thermally treating a large number of works in sequence.
It is therefore desired to enable estimation of the distance between the work and the hot plate, and then determine whether the distance between the work and the hot plate is normal or not based upon the estimated distance.
Background art for measuring a distance between an object to be treated and a thermal treatment device is known from AT 406 423 B.

SUMMARY OF THE INVENTION

The present invention was made in view of the foregoing respect. A primary object of the present invention is enabling estimation of a distance between an object to be treated such as a work and a thermal treatment means such as a hot plate. Another object is enabling detection of abnormality of thermal treatment.
In order to achieve the above objects, the present invention is configured as defined in claim 1.
Namely, the distance estimation apparatus of the present invention is an apparatus for estimating a distance between an object to be treated and a thermal treatment means in thermal treatment on the object to be treated with the thermal treatment means, comprising a distance estimation means of estimating the distance based upon information on a temperature of at least either of the object to be treated or the thermal treatment means.
Herein, the thermal treatment means refers to a means of thermally treating an object to be treated, such as a hot plate, a thermal treatment furnace, a successive furnace, and a thermocompressing part of a wrapping machine. The thermal treatment is not restricted to heating treatment, and may also be cooling treatment or heating/cooling treatment.
The thermal treatment may be thermal treatment on the entire object to be treated, or thermal treatment only on part of the object to be treated, such as the surface of the object to be treated.
The estimated distance is preferably a distance between the facing portions of the object to be treated and the thermal treatment means.
Although the thermal treatment is preferably performed by bringing the object to be treated close to the thermal treatment means, it may also be performed by bringing the thermal treatment into contact with or attached to the thermal treatment means. In such a case, it is preferable to estimate a distance between portions of the object to be treated and the thermal treatment means, the portions being neither in contact with or attached to each other.
Further, in the case of bringing the object to be treated close to the thermal treatment means to perform thermal treatment, part of the object to be treated may be in contact with the thermal treatment means.
For bringing the object to be treated close to the thermal treatment means, the object to be treated may be shifted toward the thermal treatment means, the thermal treatment means may be shifted toward the object to be treated, or both of them may be shifted.
Based upon the estimated distance, it is possible to determine whether the distance is normal or not so as to detect abnormality of thermal treatment, or it is possible to grasp the shape of the treatment surface of the object to be treated, the arranged state of the object to be treated with respect to the thermal treatment means, and the like.
In the present invention, the temperature information includes information on a temperature change after the object to be treated has been brought close to the thermal treatment means, and the larger the temperature change is, the smaller the distance estimation means estimates the distance to be.

Herein, the temperature information may include information before the object to be treated is brought close to the thermal treatment means.

It is also preferable that the temperature change information be inclination of the temperature change.

In the present invention, the temperature information includes information on a change in difference in temperature between the thermal treatment means and the object to be treated after the object to be treated has been brought close to the thermal treatment means, and the larger the change in temperature difference is, the smaller the distance estimation means estimates the distance to be.

Thus it is possible to estimate the distance between the object to be treated and the thermal treatment means based upon information on the change in temperature difference between the object to be treated and the thermal treatment means which becomes larger as the distance becomes smaller.

In a preferable embodiment of the present invention, the distance estimation means estimates the distance based upon information on an operating amount of a temperature control means of controlling the temperature of the thermal treatment means in addition to at least either piece of the temperature information.

It is preferable that this operating amount information be information on an operating amount of the temperature control means after the object to be treated has been brought close to the thermal treatment means, and the larger the operating amount is, the smaller the distance estimation means estimates the distance to be.

According to this embodiment, the distance is estimated based upon information on the operating amount in addition to the temperature information, and it is thereby possible to estimate the distance with high accuracy.

In another embodiment of the present invention, the distance estimation means comprises: a first estimation part for estimating thermal resistance between an object to be treated and a thermal treatment means; and a second estimation part for estimating the distance based upon the estimated thermal resistance.

It is preferable that thermal resistance be estimated based upon the operating amount information and the temperature information in the first estimation part, and the first estimation part comprise a model of the object to be treated which estimates the temperature of the object to be treated based upon the temperature information.

According to this embodiment, it is possible to estimate thermal resistance between the object to be treated and the thermal treatment means, so as to estimate the distance using the estimated thermal resistance.

In a preferable embodiment of the present invention, each piece of the information for use in estimation of the distance in the distance estimation means is information during part of a period when the temperature of the thermal treatment means returns to a constant temperature, after the object to be treated has been brought close to the thermal treatment means.

According to this embodiment, it is possible to estimate the distance based upon the temperature information or the operating amount information during a period when the temperature of the thermal treatment means returns to a constant temperature, namely a thermal treatment period, after the object to be treated has been brought close to the thermal treatment means.

In one embodiment of the present invention, the thermal treatment means is a hot plate with respect to which the object to be treated is placed and then thermally treated.

The object to be treated is preferably a glass substrate or the like which is placed with respect to the hot plate and then thermally treated. The distance estimation means is preferably provided with a signal indicating timing in which the object that is placed with respect to the hot plate and then thermally treated is brought close to the hot plate.

According to this embodiment, since the distance between the hot plate and the object to be treated such as the glass substrate is estimated, in a case where the object to be treated is not placed in a regular position of the hot plate, or a foreign substance or the like intervenes between the hot plate and the object to be treated and the object to be treated is then displaced from the normal distance, such positional irregularity or displacement can be detected.

In another embodiment of the present invention, the distance estimation means estimates respective distances between a plurality of points of the thermal treatment means and a plurality of corresponding points of the object to be treated.

According to this embodiment, since the distances between the plurality of points are estimated, it is possible for example to grasp the shape and deformation of the object to be treated, a positional relation of the object to be treated with respect to the thermal treatment face based upon the distances to the plurality of points with the thermal treatment face of the thermal treatment means taken as reference.

An abnormality detection apparatus of the present invention comprises: the distance estimation apparatus according to the present invention; and a determination means of determining the presence or absence of abnormality of the thermal treatment by comparison of a distance estimated by the distance estimation apparatus and a threshold.

The threshold is preferably one which corresponds to a normal distance range.

According to the present invention, comparison between the estimated distance and the threshold allows determination as to whether the thermal treatment is performed at a normal distance or not, and it is thereby possible to detect the presence or absence of abnormality of the thermal treatment.

Further, the abnormality detection apparatus of the present invention comprises: the distance estimation apparatus according to the present invention; and a determination means of determining the state of the object to be treated based upon the distances between a plurality of points which are estimated by the distance estimation apparatus, wherein abnormality is detected based upon output of the determination means.

Herein, the state of the object to be treated refers to the arranged state of the object to be treated with respect to the thermal treatment means, such as inclination of the object to be treated, the state of shape of the object to be treated, e.g. the state of deformation such as warping of the object to be treated, and some other states.

According to the present invention, since the state of the object to be treated is determined based upon the distances between the plurality of the points, it is possible to detect abnormality of thermal treatment for example in a state where the object to be treated runs on a foreign subject or the like, or is deformed.

A temperature regulator of the present invention comprises the distance estimation apparatus according to the present invention, and controls a temperature of the thermal treatment means.

According to the present invention, the temperature information of the thermal treatment means is given and also the temperature regulator itself which outputs operating amount information can estimate the distance.

In one embodiment of the present invention, the temperature of the thermal treatment means is controlled such that a temperature detected by a temperature detection means of detecting a temperature of the thermal treatment means is a set temperature. The temperature regulator comprises a correction means of correcting at least either of the set temperature or the detected temperature based upon the distance estimated by the distance estimation apparatus.

The correction means preferably makes correction so as to make the degree of thermal treatment stronger with a larger estimated distance.

According to this embodiment, in the case where the distance is displaced from a normal distance, it is possible to correct the degree of thermal treatment according to an amount of the displacement so as to perform normal thermal treatment.

Further, the temperature regulator of the present invention comprises the abnormality detection apparatus according to the present invention, wherein the temperature of the thermal treatment means is controlled.

According to the present invention, it is possible to detect abnormality of thermal treatment while controlling the temperature of the thermal treatment means.

The thermal treatment apparatus of the present invention comprises: the temperature regulator according to the present invention; the thermal treatment means; an operation means of heating and/or cooling the thermal treatment means based upon output of the temperature regulator; and a temperature detection means of detecting the temperature of the thermal treatment means.

According to the present invention, it is possible to provide the thermal treatment apparatus capable of detecting abnormality of thermal treatment.

According to the present invention, since the distance between the object to be treated and the thermal treatment means can be estimated based upon temperature information of at least one of the object to be treated and the thermal treatment means, it is possible to determine whether the distance is normal or not to detect abnormality of thermal treatment, or to grasp the shape and the arranged state of the object to be treated.

BRIEF DESCRIPTION OF THE DRAWINGS

Fig. 1 shows a schematic constitutional view of a system comprising a temperature regulator according to one embodiment of the present invention;
Fig. 2 shows a schematic view of a positional relation between a work and a hot plate;
Fig. 3 shows a view for explaining a basic idea of distance estimation of the embodiment of Fig. 1;
Fig. 4 shows a view of a change in temperature of the hot plate;
Fig. 5 shows inclination of the hot plate temperature;
Fig. 6 shows a schematic constitutional view of a system comprising a temperature regulator according to another embodiment of the present invention;
Fig. 7 shows a view for explaining a basic idea of distance estimation of the embodiment of Fig. 6;
Fig. 8 shows a view of the estimated distance of the embodiment of Fig. 6;
Fig. 9 shows a schematic constitutional view of a system comprising a temperature regulator according to another embodiment of the present invention;
Fig. 10 shows a view of a work model of Fig. 9;
Fig. 11 shows a block diagram of an abnormality detection apparatus of another embodiment of the present invention; and
Fig. 12 shows a block diagram of a main part of a temperature regulator of another embodiment of the present invention.

DETAILED DESCRIPTION OF THE PREFERRED EMBODIMENTS

In the following, embodiments of the present invention are specifically described based upon drawings.

Embodiment 1

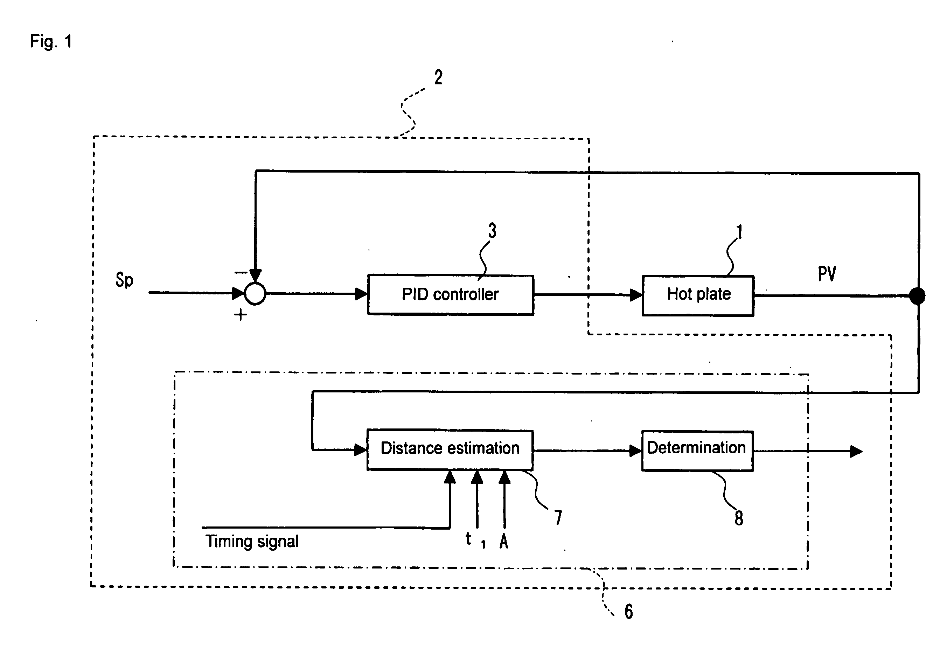

Fig. 1 shows a schematic constitutional view of a thermal treatment apparatus according to one embodiment of the present invention.

A description is given to application of this embodiment to an apparatus where a work such as a glass substrate as the object to be treated is placed with respect to a hot plate 1 as the thermal treatment means and then thermally treated.

In this embodiment, the temperature of the hot plate 1 where the work is thermally treated is detected with a temperature sensor provided inside the hot plate 1, and then inputted into a temperature regulator 2 according to the present invention. In the temperature regulator 2, a PID calculation or the like is performed with a PID controller 3 as the temperature control means based upon a deviation of a target temperature (set temperature) SP having been set and a detected temperature PV, to output an operating amount for controlling passage of a current of a heater (not shown) arranged on the hot plate 1 via an electromagnetic switch (not shown) or the like such that the temperature of the hot plate 1 is the target temperature SP.

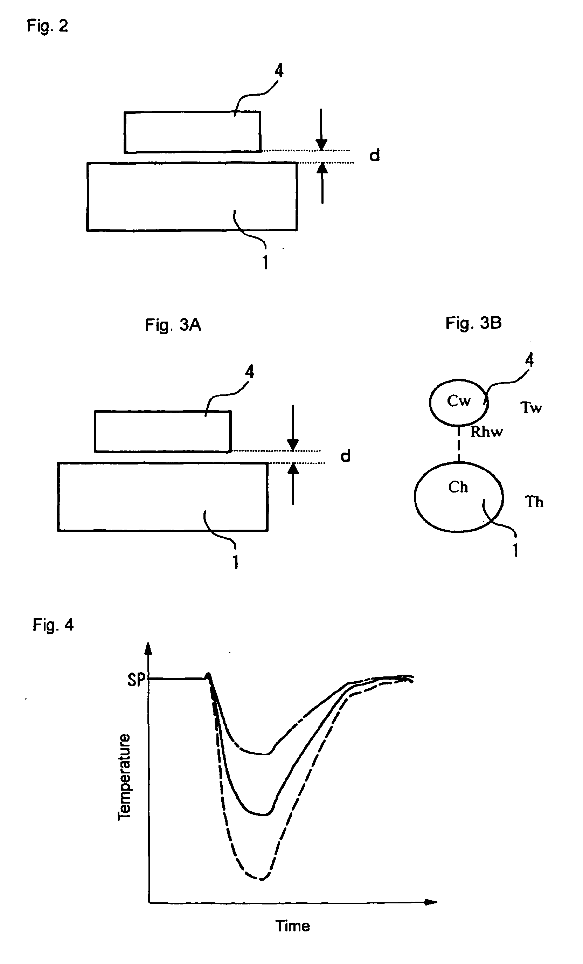

In this thermal treatment apparatus, as shown in Fig. 2, each work 4 to be thermally treated with the hot plate 1 is automatically placed with respect to the hot plate 1 by a conveyance supply means (not shown), and thermally treated in sequence. In a normal state, part of the work 4 such as a glass substrate is placed in the state apart from the hot plate 1 by a constant distance d by being supported by a supporting part (not shown).

This embodiment is configured as follows. A distance d between the hot plate 1 and the work 4 when placed with respect to the hot plate 1 to be thermally treated is estimated as described later, and it is determined whether the distance is normal or not based upon the estimated distance d. When the distance between the work 4 and the hot plate 1 is abnormal, for example when the distance is larger than the normal distance and the thermal treatment is thus incomplete, such abnormality can be detected.

Namely, in this embodiment, as shown in Fig. 1, the temperature regulator 2 houses an abnormality detection apparatus 6 which estimates the distance between the work 4 and the hot plate 1 based upon the temperature PV of the hot plate 1 after placement of the work 4 with respect to the hot plate 1 to determine whether the estimated distance is within a normal range or not and to detect abnormality of thermal treatment.

The abnormality detection apparatus 6 of this embodiment comprises: a distance estimation means 7 for estimating the distance between the work 4 and the hot plate 1 based upon inclination of temperature of the hot plate 1; and a detection means 8 for detecting whether the thermal treatment is normal or not based upon the estimated distance d. The distance estimation means 7 is provided with a timing signal corresponding to timing in which the work 4 is placed with respect to the hot plate 1, from a host apparatus for controlling throughout thermal treatment as described later, while also provided with later-described setting information t1, A, etc., which is set by the user and required for distance estimation.

The PID controller 3, the abnormality detection apparatus 6 and the like are configured for example by a microcomputer.

Herein, the object to be treated is the work 4, and the thermal treatment means is the hot plate 1. Based upon Fig. 3, a basic idea of distance estimation is described.

In the case where the work 4 and the hot plate 1 are close to each other to a degree that the influence of heat transfer due to radiation does not need considering, the following relation holds between the work 4 and the hot plate 1.

It is to be noted that, as shown in Fig. 3, the distance between the work 4 and the hot plate 1 is d, the temperature of the work 4 is Tw, the temperature of the hot plate 1 is Th, a heat capacity of the work 4 is Cw, a heat capacity of the hot plate 1 is Ch, and thermal resistance therebetween is Rhw.

Rate $\Delta Th$ $(= dTh/dt)$ of the temperature change of the hot plate 1

$$\propto \text{(Work temperature Tw} - \text{Hot plate temperature Th) / Thermal resistance}$$

$$\text{Rhw}$$

$$\propto \text{(Work temperature Tw} - \text{Hot plate temperature Th) / Distance d.}$$

Therefore,

$$\text{Distance d} \propto \text{(Work temperature Tw} - \text{Hot plate temperature Th) / Rate}$$

$$\Delta\text{Th (= dTh/dt) of temperature change of hot plate}$$

$$\text{Distance d} = k \times \text{(Work temperature Tw} - \text{Hot plate temperature Th) / Rate}$$

$$\Delta\text{Th (= dTh/dt) of temperature change of hot plate}$$

Herein, when respective initial temperatures TwO, Th0 of the work 4 and the hot plate 1 at the moment of placement of the work 4 with respect to the hot plate 1 is known, e.g. when the initial temperatures of the work 4 and the hot plate 1 are stable, (work initial temperature Tw0 - Hot plate initial temperature Thw) is regarded as a constant, and the distance d at the moment of placement of the work 4 with respect to the hot plate 1 can be estimated in the following expression.
$$[0065] \quad \text{Distance d} = \text{Constant k / Rate } \Delta\text{Th of temperature change of hot}$$

$$\text{plate (inclination of temperature of hot plate)} \quad\quad\quad \text{... (a)}$$

In this embodiment, Rate $\Delta$Th of temperature change of the hot plate 1 is the temperature inclination of the hot plate 1, and this temperature inclination of the hot plate 1 is measured to estimate the distance d between the work 4 and the hot plate 1 by means of a previously obtained constant k.

It is to be noted that in a state where the distance d between the work 4 and the hot plate 1 is set to a known distance, thermal treatment is performed and the temperature of the hot plate 1 is measured to calculate the temperature inclination of the hot plate 1 so that the constant k can be previously obtained.

Fig. 4 is a view showing how the temperature of the hot plate 1 changes with the distance between the work 4 and the hot plate 1, and also showing a temperature change of the hot plate 1 when the work 4 is placed with respect to the hot plate 1 in the state of having been heated to be adjusted to a target temperature SP with a distance therebetween excessively large (dashed line), normal (solid line) and excessively small (broken line).

As shown in this Fig. 4, when the work 4 is placed with respect to the hot plate 1 with a distance larger than normal distance (excessively large distance) and then thermally treated, as shown by the dashed line, heat shifts to the work 4 in a smaller amount and a temperature decrease of the hot plate 1 is smaller than in the normal case.

As opposed to this, when the work 4 is placed with respect to the hot plate 1 with a distance smaller than normal distance (excessively small distance) and then thermally treated, as shown by the broken line, heat shifts to the work 4 in a larger amount and a temperature decrease of the hot plate 1 is larger than in the normal case.

As thus described, it is found that a degree of the temperature decrease of the hot plate 1, namely the inclination of the temperature of the hot plate 1, changes according to the distance between the work 4 and the hot plate 1, and the distance between the work 4 and the hot plate 1 changes according to the inclination of the temperature of the hot plate 1 as described using the foregoing expression (a).

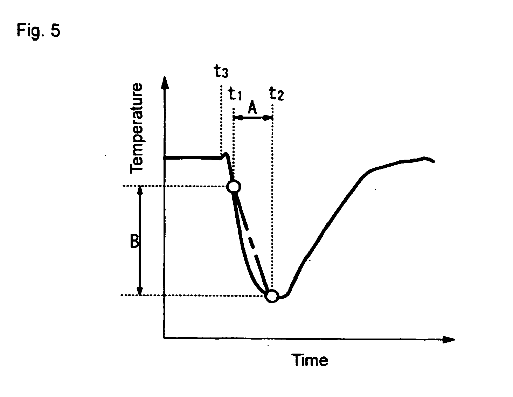

In this embodiment, as shown in Fig. 5, a temperature at a first time point t1 after the work 4 has been placed with respect to the hot plate 1 and thermal treatment has been started, and a temperature at a second time point t2 when a given period of time lapses from the first time point t1 are separately measured, to calculate a temperature change width B of the hot plate 1 with respect to the constant time width A, namely the inclination of temperature of the hot plate 1 (= B/A).

The point at which the temperature of the hot plate 1 is measured is preferably near a point from which the distance is wished to be measured, and is preferably in a portion where an influence by shift of heat due to approach of the work 4 is apt to appear. Namely, the point at which the temperature is measured is preferably in the vicinity of the surface of the side closer to the work 4. Further, the point is preferably far apart from a heater and a heat source which might cause a disturbance. The number of points, from which a distance is estimated, may be one or more than one.

It is preferable to calculate the inclination of the temperature of the hot plate 1 by using the temperature of the hot plate 1 during at least part of a period from the time point at which the temperature of the hot plate 1 falls to the time point at which the temperature decreases to the lowest.

Based upon the inclination of temperature of the hot plate 1 calculated as thus described and the previously determined constant k, the distance d is estimated according to the foregoing expression (a).

The temperature regulator 2 shown in Fig. 1 is configured such that a timing signal corresponding to timing in which the work 4 is placed with respect to the hot plate 1, from a higher-level apparatus for controlling throughout thermal treatment. This timing signal corresponds, for example, to a timing point t3 shown in Fig. 5.

Next, a description is given to a procedure for distance estimation as well as abnormality detection by means of the temperature regulator 2 shown in Fig. 1.

First, a process is performed for determining the foregoing constant k, constant time width A, and the like, prior to actual operation of thermally treating each work 4 in sequence by the hot plate 1.

In this process, the work 4 is placed with respect to the hot plate 1 to be thermally treated such that the distance between the work 4 and the hot plate 1 is a known normal distance, and the temperature of the hot plate 1 is measured.

Based upon a waveform of the measured temperature of the hot plate 1, the first time point t1 and the constant time width A are set into the temperature regulator 2 with the foregoing time point t3 of the timing signal of Fig. 5 as a reference, and the known distance is set into the temperature regulator 2.

The distance estimation means 7 of the temperature regulator 2 calculates an inclination of the measured temperature of the hot plate 1 based upon the set first time point t1 and the constant time width A, and further calculates the foregoing constant k by use of the set known distance.

As thus described, an actual operation of thermal treatment on the work is started after the constant time width A and the constant k have been set into the distance estimation means 7 of the temperature regulator 2.

In this thermal treatment, every time the work 4 is placed with respect to the hot plate 1 and then thermally treated, the distance estimation means 7 estimates the distance between the work 4 and the hot plate 1 according to the foregoing expression (a), and the determination means 8 determines whether the distance is within a normal range or not by comparison with a threshold which corresponds to the normal range. When the distance is out of the normal range, a detection signal indicating abnormality of thermal treatment is outputted, for example, to a higher-level apparatus so that the higher-level apparatus can take an appropriate measure such as notifying abnormality of thermal treatment or halting thermal treatment.

Embodiment 2

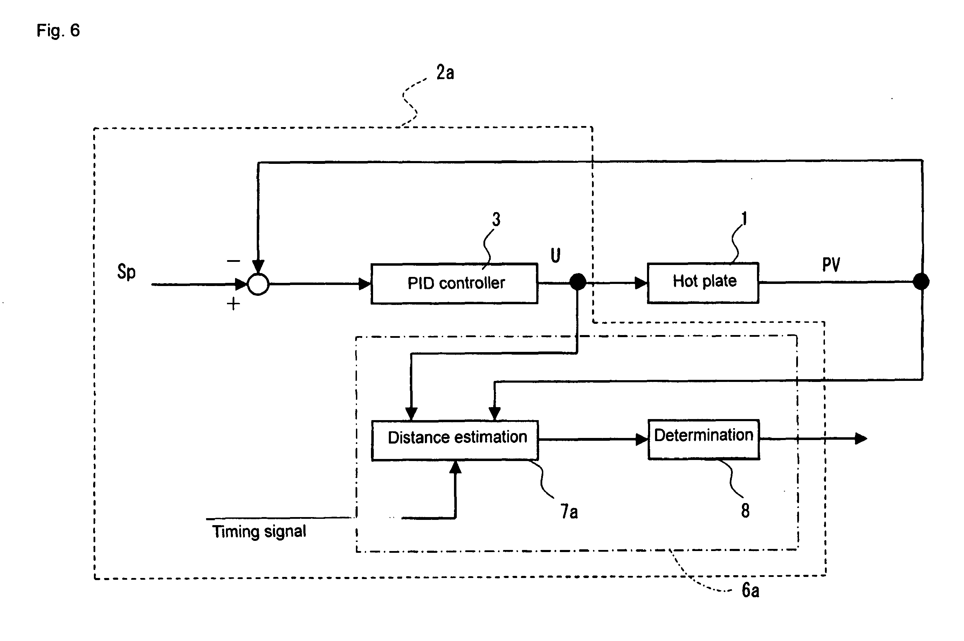

Fig. 6 shows a schematic constitutional view of the thermal treatment device according to another embodiment of the present invention. Portions corresponding to those in Fig. 1 described above are provided with the same reference numerals as in Fig. 1

In the foregoing embodiment, the distance between the work 4 and the hot plate 1 is estimated based upon the temperature inclination of the hot plate 1. As opposed to this, in this embodiment, the distance between the work 4 and the hot plate 1 is estimated based upon the temperature of the hot plate 1 and an operating amount U obtained from the PID controller 3.

Herein, a basic idea of distance estimation in this embodiment is described.

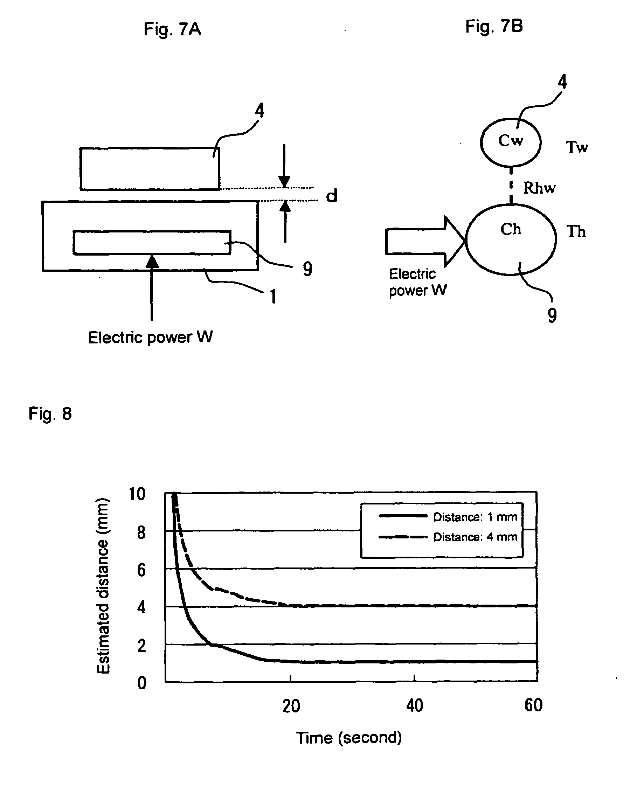

It is to be noted that in the following description, as shown in Fig. 7, the distance between the work 4 and the hot plate 1 is d, the temperature of the work 4 is Tw, the temperature of the hot plate 1 is Th, a heat capacity of the work 4 is Cw, a heat capacity of the hot plate 1 is Ch, thermal resistance therebetween is Rhw, and electric power to be supplied to the heater of the hot plate 1 is W.

Generally, the heat amount of the hot plate 1 is expressed by the following expression.

[Mathematical Expression 1]

Heat amount of hot plate = Initial value of heat amount of hot plate +

$$\int \text{amount of heat shifted to work} + \int \text{heat value dt of heater} \qquad \dots (1)$$

Further,

[Mathematical Expression 2]

Hot plate heat capacity Ch × Hot plate temperature Th = Initial value of heat amount of hot plate + $\int$ (temperature difference / thermal resistance) dt + $\int$ heat value dt of heater

... (2)

The above expression (2) is differentiated by time.

Ch×dTh dt = (Temperature difference / Heat resistance) + Heat value of heater = {(Work temperature Tw - Hot plate temperature Th) / Thermal resistance Rhw} + Electric power W

Therefore,

$$dTh/dt = \{(Tw - Th)/Rhw \times Ch\} + W/ch$$

Herein, when the thermal resistance Rhw is proportional to the distance d between the work and the hot plate, the heat capacitance Ch of the hot plate is kept constant, and k0 is a constant,

$$dTh/dt \propto \{(Tw - Th)/d\} + k0 \cdot W$$

When dTh/dt = ΔTh, the distance d is:

$$dt \{(Tw - Th)/(\Delta Th - k0 \cdot W).$$

When k2 is a proportionality constant,

$$d = k2(Tw - Th)/(\Delta Th - k0 \cdot W).$$

When k0 · W = k1 · U,

$$d = k2(Tw - Th)/(\Delta Th - k1 \cdot W). \quad\quad ... (3)$$

Therefore, previously obtaining the proportionality constants k1 and k2 enables estimation of the distance from the work temperature Tw, the operating amount U and the inclination ΔTh of temperature of the hot plate.

It is to be noted that:

8

$$\Delta Th = dTh/dt$$

$$\approx \{Th(n)-Th(n-1)\}/ \Delta t,$$

Where $\Delta t$ is sampling time.

Herein, since the relation between the operating amount U and the electric power W is determined in terms of design, the constant k1 of the above expression (3) can be determined.

Further, thermal treatment is performed in a state where the distance between the work 4 and the hot plate 1 has been set to a known distance, and using the temperature Tw of the work 4, the temperature Th of the hot plate 1 and the operating amount U in that state, it is possible to obtain the constant k2.

In this embodiment, each work 4 is placed with respect to the hot plate 1 to be thermally treated in sequence, and it is not easy to detect the temperature of every work 4 to be thermally treated.

Therefore, in this embodiment, the temperature Tw of the work 4 is estimated by use of a temperature model of the work 4.

Namely, in this embodiment, a distance estimation means 7a of Fig. 6 estimates a work temperature Tw by the following expression, based upon the distance d calculated by the foregoing expression (3) and the temperature Th of the hot plate.

$$Tw(n) = k3 \cdot Tw(n-1)+k4 \cdot \{(Th(n-1)-Tw(n-1))/d$$

Namely, the temperature Tw(n) of the work in the present sampling is estimated using a temperature Tw(n-1) of the work in the last sampling, a temperature Th(n-1) of the hot plate 1 in the last sampling and a distance d estimated in the last sampling.

Herein, the constants k3 and k4 can be previously determined by measurement of the temperature Tw of the work 4 and the temperature Th of the hot plate 1 in thermal treatment with a known distance d.

In this embodiment, in the distance estimation means 7a of a temperature regulator 2a, based upon the temperature of the hot plate 1, the temperature of the work estimated based upon the temperature of the hot plate 1, and the operating amount U, the distance is estimated according to the foregoing expression (3).

Other configurations are the same as those of the foregoing embodiment.

Fig. 8 shows one example of data of distance estimation according to this embodiment.

Fig. 8 shows changes in estimated distance between the work 4 and the hot plate 1 when the distance is set to 1 mm and 4 mm, respectively. As the work 4 is brought closer to the hot plate 1 with the passage of time, the respective estimated distances become smaller, and then are kept constant at 1 mm and 4mm.

In this embodiment, although the distance is estimated based upon the temperature and the operating amount of the hot plate 1, as another embodiment of the present invention, the distance may be estimated based upon the temperature of the hot plate 1, the temperature of the work 4 and the operating amount.

Embodiment 3

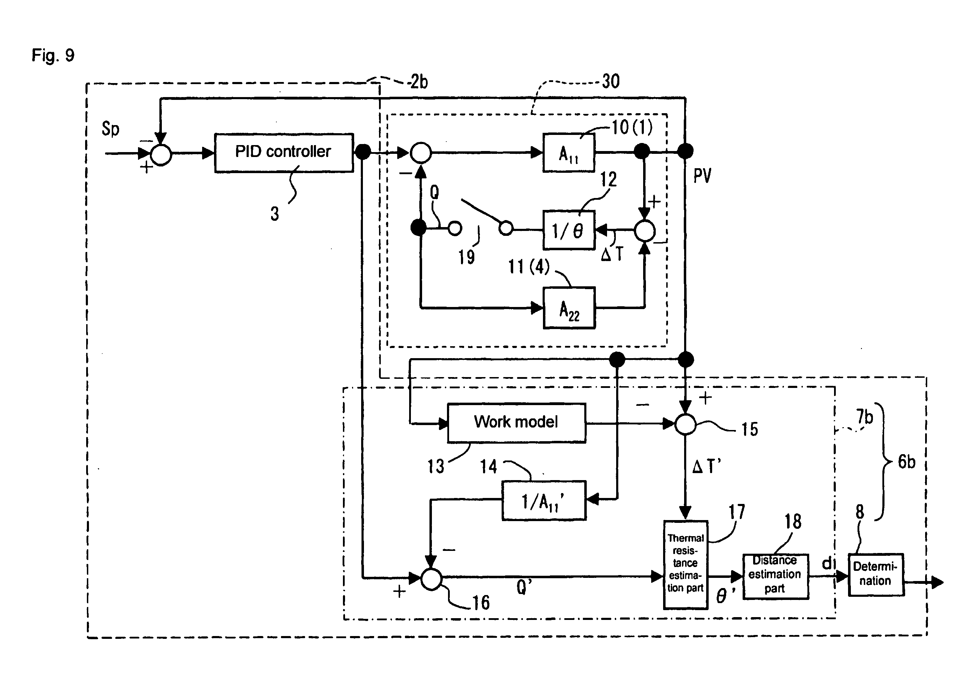

Fig. 9 shows a schematic constitutional view of the thermal treatment apparatus according to still another embodiment of the present invention. Portions corresponding to those in Fig. 1 described above are provided with the same reference numerals as in Fig. 1.

In this embodiment, the distance is estimated through the use of a model structure under control which is appropriate for decoupling control which was previously proposed by the applicant of this invention as a "model structure, control apparatus, temperature regulator and thermal treatment apparatus" in Japanese Patent Application Laid-Open No. 2004-94939 (Japanese Patent Application No. 2003-289867).

A model structure 30 under control shown in Fig. 9 comprises a model element 10 corresponding to the hot plate 1 and a model element 11 corresponding to the work 4, a difference in output (temperature difference) between the model elements 10 and 11 is fed back to the input sides of the model elements 10 and 11 with the poles thereof made different through a feedback element 12.

This model represents in a block diagram a heat shifting phenomenon of in which a heat amount shifts from the hot plate 1 (10) to the work 4(11) due to the temperature difference between the hot plate 1(10) and the work 4(11), and the heat amount is removed from the hot plate 1(10) (negative) while the heat amount is added to the work 4(11) (positive).

This model (hereinafter referred to as "temperature difference model") is equivalent to Fourier's law which states that a heat amount shifts when there is a temperature difference and the shift of the heat amount is proportional to the temperature difference.

It is to be noted that, in Fig. 9, $A_{11}$, $A_{22}$ are transfer functions of the model elements 10 and 11 which correspond to the hot plate 1 and the work 4, respectively. The feedback element 12 shows shifting of the heat amount according to the temperature difference. $\theta$ is thermal resistance between the hot plate 1 and the work 4.

Further, before placement of the work 4 with respect to the hot plate 1, a switch means 19 on the output side of the feedback element 12 is turned off so that the temperature difference between the work 4 and the hot plate 1 is not fed back. When the work 4 is placed with respect to the hot plate 1, the switch means 19 is turned on and the temperature difference between the work 4 and the hot plate 1 is fed back.

As shown in Fig. 9, when objects under control, including the hot plate 1 and the work 4, are grasped by means of the temperature difference model, obtaining thermal resistance $\theta$ between the hot plate 1 and the work 4 allows estimation of the distance d between the work 4 and the hot plate 1 based upon a thermal conductivity K of the air and a facing area S of the work 4 and the hot plate 1, using the following expression:

$$d = Ka \cdot S \cdot \theta$$

As shown in Fig. 9, an input $\Delta T$ and an output Q of the feedback element are estimated and the input $\Delta T$ is divided by the output Q, to allow estimation of the thermal resistance $\theta$.

Therefore, the distance estimation means 7b of a temperature regulator 2d of this embodiment comprise a work model 13 for estimating a work temperature and an estimation element 14 for estimating a heat amount (heat current) through the hot plate 1 per one hour according to the temperature of the hot plate 1.

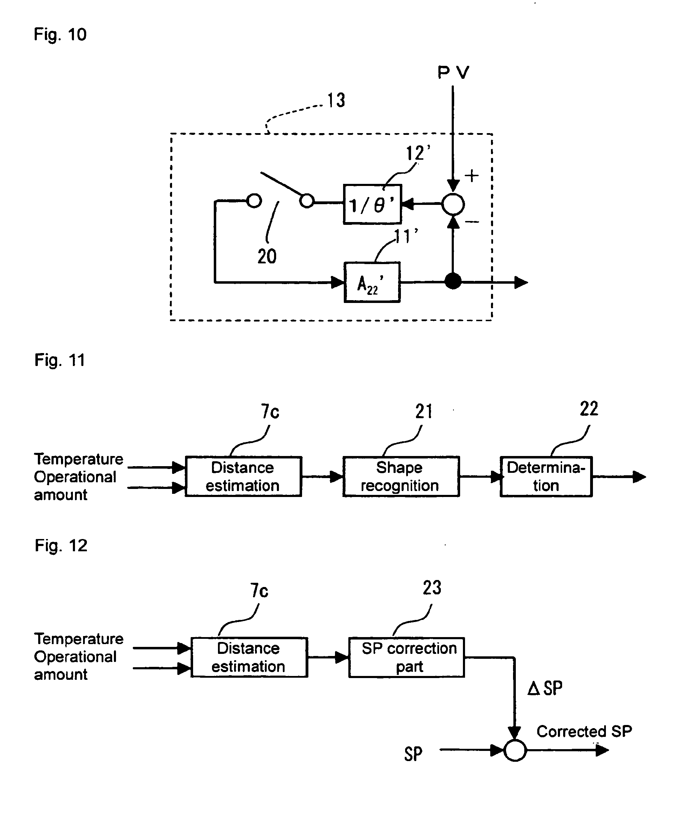

In this embodiment, as shown in Fig. 10, the work model 13 comprises compensation elements 11' and 12' of transfer functions $A'_{22}$, $1/\theta'$ as in the case of the model element 11 and the feedback element 12 of the temperature difference model, and further has a switch means 20 corresponding to the switch means 19. According to a timing signal from the higher-level apparatus, the work model 13 is turned on when the work 4 is placed with respect to the work 4, and turned off when thermal treatment is completed.

It is to be noted that this work model 13 is not required to correspond to the temperature difference model, and may be another model such as an ARX model or a transfer function model, as long as being capable of estimating the temperature of the work 4 from the temperature of the hot plate 1.

The estimation element 14 corresponds to the model element 10 of the hot plate 1 of the temperature difference model, and an inverse number $1/A'_{11}$ of the transfer function $A_{11}$ of the model element 10 is a transfer function.

In this embodiment, while a temperature difference $\Delta T'$ between a temperature PV of the hot plate 1 and a work temperature estimated by means of the work model 13 is calculated in a subtraction part 15, a heat current which was estimated in the estimation element 14 and flown into the hot plate 1 from a heat current generated from a heater is subtracted in a subtraction part 16 to calculate a heat current Q' that flows between the hot plate 1 and the work 4. In a thermal resistance estimation part 17, the estimated temperature difference $\Delta T'$ is divided by the estimated heat current Q' to estimate the thermal resistance $\theta'$, and using this thermal resistance $\theta'$, the heat conductivity Ka of the air and the facing area S of the work 4 and the hot plate 1, the estimated distance d between the work 4 and the hot plate 1 is calculated in the distance estimation part 18.

It is to be noted that the heat current to be inputted into the subtraction part 16 from the PID controller 3 can be obtained by direct calculation when the output value of the PID controller 3 is a heat current itself, or by calculation according to the output value from the PID controller 3 when the output value is an operating amount.

The distance estimation means 7b of this embodiment comprises: a first estimation part for estimating thermal resistance between the work 4 and the hot plate 1; and a second estimation part for estimating a distance based upon the estimated thermal resistance.

It is to be noted that the transfer function $A_{11}$ of the hot plate 1 is for example a primary delay system, and can be obtained for example from the maximum inclination formed by auto tuning. Further, the transfer function of the work 4 is the primary delay system which includes a constant corresponding to the heat capacity of the work 4 and a constant according to the thermal resistance of the work 4, and for example, the heat capacity can be obtained from a material and a size of the work 4.

Other Embodiments

Although the determination means 8 determines the presence or absence of abnormality by comparison of the estimated distance and the threshold in the foregoing embodiment, the following operation may also be performed as another embodiment of the present invention. Respective distances between a plurality of points of the work and the hot plate are separately estimated, and the shape, inclination and the like of the work are determined based upon the estimated distances between those plurality of points so as to detect abnormality.

Namely, as shown in Fig. 11, a distance estimation part 7c estimates respective distances between a plurality of points of the work 4 and the hot plate 1 based upon a temperature and an operating amount, as in each of the foregoing embodiments. A shape recognition part 21 recognizes the shape of the work based upon those plurality of estimated distances. A determination part 22 determines whether the recognized shape has exceeded the threshold or not, and then outputs an abnormality detection signal indicating abnormality of the shape of the work 4 when the shape has exceeded the threshold.

For example, when the treatment surface of the work 4 is flat, the shape recognition part 21 calculates a difference (dmax - dmin) between the maximum estimated distance (dmax) and the minimum estimated distance (dmin) among the plurality of estimated distances, to recognize a flatness. The determination part 22 determines whether this flatness has exceeded a certain range (threshold) or not, and then outputs an abnormality detection signal indicating abnormality of the shape of the work 4 when the flatness has exceeded the threshold.

Or, when the treatment surface of the work 4 is in the shape of a saucer or a mountain, the shape recognition part 21 calculates a difference (d1-d2) between an estimated distance d1 of the central part of the work 4 and an estimated distance d2 of the periphery, to recognize a curving degree. The determination part 22 determines whether this curving degree has exceeded a certain range (threshold) or not, and then outputs an abnormality detection signal indicating abnormality of the shape of the work 4 when the curving degree has exceeded the threshold.

Further, for example, when a foreign substance intervenes between the work 4 and the hot plate 1 and the work 4 is placed onto the work 4 to become inclined, the shape of the work 4 might be improperly detected as abnormal although it is normal. In order to prevent such an improper detection, a plurality of points for distance estimation are provided point-symmetrically on a concentric circle and an average value of those estimated distances is set to d2ave, whereby it is possible to cancel the inclination of the work 4 due to placement thereof onto the foreign substance by setting the foregoing curving degree to d1-d2ave.

It is to be noted that, when the treatment surface of the work 4 is flat, the difference (dmax - dmin) between the maximum estimated distance (dmax) and the minimum estimated distance (dmin) among a plurality of estimated distances may be calculated, followed by comparison with the threshold, to detect abnormality that the work 4 has placed onto the foreign substance or the like and become inclined.

Further, as another embodiment of the present invention, the following operation may be performed. When the estimated distance is larger than a normal distance, a target temperature is corrected to be higher so as to increase heat application. As opposed to this, when the estimated distance is smaller than the normal distance, a target temperature is corrected to be lower so as to decrease heat application.

Namely, as shown in Fig. 12, a target temperature correction part 23 may calculate a target temperature correction value ΔSP based upon an estimated distance estimated in the distance estimation part 7c so that the target temperature SP is corrected using the target temperature correction value ΔSP. As this target temperature correction value ΔSP, for example, a correction value to be calculated by the following expression can be employed.

ΔSP(t) = (Reference hot plate temperature (t) – Reference work temperature (t)) (d(t) – Reference distance d0) / d0

Herein, the time t is time when a signal indicating the work is measured as a trigger.

Further, the reference hot plate temperature and the reference work temperature are previously obtained respond waveforms (time-series temperature data) of the hot plate and the work in a case where the distance is normal (reference distance).

Due to such correction of the target temperature, for example, an increase in temperature of the work 4 is delayed when the distance between the work 4 and the hot plate 1 is large. In order to make the increase faster, the target temperature is increased. It is to be noted that the detected temperature provided from the temperature sensor may be corrected in place of correction of the target temperature.

Although the respective abnormality detection apparatuses 6, 6a and 6b were built in the temperature regulators 2, 2a and 2b in the foregoing embodiments, the abnormality detection apparatus may be configured as a separate apparatus from the temperature regulator. Further, only the distance estimation means may be configured as another independent distance estimation apparatus.

Although the thermal treatment surface of the thermal treatment means was flat in the foregoing embodiments, the shape of the surface is not restricted to flat, but may be arbitral, such as curved or concavo-convex, and the shape of the object to be treated may also be arbitral.

Although the object to be treated such as a work is placed with respect to the thermal treatment means such as a hot plate to be thermally treated in the foregoing embodiments, the object to be treated may be brought close to and passed through the thermal treatment means for thermal treatment, or the object to be treated may be brought into contact with the thermal treatment means for thermal treatment.

The present invention is useful for example for detection of abnormality in thermal treatment such as thermal treatment on a work by means of a hot plate, and the like.

**Claims**

1.  A distance estimation apparatus (7) for estimating a distance (d) between an object (4) to be treated and a thermal treatment device (1) in thermal treatment performed by bringing the object (4) to be treated close to the thermal treatment device (1), comprising:

    a distance estimation device (7) for estimating the distance (d) based upon information on a temperature of at least either of the object (4) to be treated or the thermal treatment device (1), wherein the temperature information includes information on a change in difference in temperature between the thermal treatment device (1) and the object (4) to be treated after the object (4) to be treated has been brought close to the thermal treatment device (1), and the larger the change in temperature difference is, the smaller the distance estimation device (7) estimates the distance (d) to be.

2.  The distance estimation apparatus according to claims 1, wherein the distance estimation device (7a) being adaptive to input of an operating amount of a temperature control device (3) and estimates the distance based upon information on the operating amount of the temperature control device for controlling the temperature of the thermal treatment device in addition to at least either piece of the temperature information,
    wherein the operating amount information is information on the operating amount of the temperature control device (3) after the object to be treated has been brought close to the thermal treatment device, and the larger the operating amount is, the smaller the distance estimation device estimates the distance to be.

3.  The distance estimation apparatus according to claim 2, the distance estimation device (7b) further comprising: a first estimation part (17) for estimating thermal resistance between an object to be treated and a thermal treatment device; and a second estimation part (18) for estimating the distance based upon the estimated thermal resistance.

4.  The distance estimation apparatus according to any of claims 1 to 3, wherein each piece of the information for use in estimation of the distance is information during part of a period when the temperature of the thermal treatment device returns to a constant temperature, after the object to be treated has been brought close to the thermal treatment device.

5.  The distance estimation apparatus according to any one of claims 1 to 4, wherein the thermal treatment device is a hot plate (1) with respect to which the object to be treated is placed and then thermally treated.

6.  The distance estimation apparatus according to any one of claims 1 to 5, wherein the distance estimation device estimates respective distances between a plurality of points of the thermal treatment device and a plurality of corresponding points of the object to be treated.

7.  The distance estimation apparatus according to any one of claims 1 to 6, wherein the thermal treatment is at least either one of heating treatment or cooling treatment.

8.  An abnormality detection apparatus (6, 6a, 6b), comprising:

    the distance estimation apparatus (7, 7a, 7b) according to any one of claims 1 to 7; and a determination device (8) for determining the presence or absence of abnormality of the thermal treatment by comparison of a distance estimated by the distance estimation apparatus and a threshold.

9. An abnormality detection apparatus, comprising: the distance estimation apparatus according to claim 7; and a determination device (8) for determining the state of the object to be treated based upon the distances between a plurality of points which are estimated by the distance estimation apparatus, wherein abnormality is detected based upon output of the determination device.

10. A temperature regulator (2, 2a, 2b), comprising the distance estimation apparatus according to any one of claims 1 to 7, wherein a temperature of the thermal treatment device is controlled.

11. The temperature regulator according to claim 10 for controlling the temperature of the thermal treatment device such that a temperature detected by a temperature detection device for detecting a temperature of the thermal treatment device is equal to a set temperature, further comprising a correction device (23) for correcting at least either of the set temperature or the detected temperature based upon the distance estimated by the distance estimation apparatus.

12. The temperature regulator according to claim 10 or 11, further comprising the abnormality detection apparatus according to claim 8 or 9, wherein the temperature of the thermal treatment device is controlled.

13. A thermal treatment apparatus, comprising: the temperature regulator (2) according to any one of claims 10 to 12; the thermal treatment device (1); an operation device for heating and/or cooling the thermal treatment device based upon output of the temperature regulator; and a temperature detection device for detecting the temperature of the thermal treatment device.

**Patentansprüche**

1. Abstandsschätzvorrichtung (7) zur Abschätzung eines Abstands (d) zwischen einem zu behandelnden Objekt (4) und einer Wärmebehandlungsvorrichtung (1) bei einer Wärmebehandlung, die durchgeführt wird, indem das zu behandelnde Objekt (4) in die Nähe der Wärmebehandlungsvorrichtung (1) gebracht wird, aufweisend:

   eine Abstandsschätzvorrichtung (7) zur Abschätzung des Abstands (d) beruhend auf Information zur Temperatur des zu behandelnden Objekts (4) und/oder der Wärmebehandlungsvorrichtung (1), wobei die Temperaturinformation Information über eine Änderung der Temperaturdifferenz zwischen der Wärmebehandlungsvorrichtung (1) und dem zu behandelnden Objekt (4) nach Bringen des zu behandelnden Objekts (4) in die Nähe der Wärmebehandlungsvorrichtung (1) enthält, wobei die Abstandsschätzvorrichtung (7) den Abstand (d) umso kleiner einschätzt je größer die Änderung der Temperaturdifferenz ist.

2. Abstandsschätzvorrichtung nach Anspruch 1, wobei die Abstandsschätzvorrichtung (7a) an eine Eingabe einer Stellgröße einer Temperaturregelvorrichtung (3) adaptiv ist und den Abstand beruhend auf Information über die Stellgröße der Temperaturregelvorrichtung zur Regelung der Temperatur der Wärmebehandlungsvorrichtung zusätzlich zu wenigstens einem der beiden Elemente von Temperaturinformation abschätzt,

   wobei die Stellgrößeninformation Information über die Stellgröße der Temperaturregelvorrichtung (3) nach Bringen des zu behandelnden Objekts in die Nähe der Wärmebehandlungsvorrichtung ist, wobei die Abstandsschätzvorrichtung der Abstand umso kleiner einschätzt je größer die Stellgröße ist.

3. Abstandsschätzvorrichtung nach Anspruch 2, wobei die Abstandsschätzvorrichtung (7b) ferner aufweist: einen ersten Schätzteil (17) zum Abschätzen des Wärmewiderstands zwischen einem zu behandelnden Objekt und einer Wärmebehandlungsvorrichtung; und einen zweiten Schätzteil (18) zur Abschätzung des Abstandes beruhend auf dem geschätzten Wärmewiderstand.

4. Abstandsschätzvorrichtung nach einem der Ansprüche 1 bis 3, wobei jedes Element der Information zur Verwendung bei der Schätzung des Abstands Information während eines Teils einer Zeitdauer ist, in der die Temperatur der Wärmebehandlungsvorrichtung auf eine konstante Temperatur zurückkehrt, nachdem das zu behandelnde Objekt in die Nähe der Wärmebehandlungsvorrichtung gebracht worden ist.

5. Abstandsschätzvorrichtung nach einem der Ansprüche 1 bis 4, wobei die Wärmebehandlungsvorrichtung eine Heizplatte (1) ist, in Bezug auf welche das zu behandelnde Objekt angeordnet und dann wärmebehandelt wird.

6. Abstandsschätzvorrichtung nach einem der Ansprüche 1 bis 5, wobei die Abstandsschätzvorrichtung Abstände zwischen einer Anzahl von Punkten der Wärmebehandlungsvorrichtung und eine Anzahl entsprechender Punkte des zu behandelnden Objekts abschätzt.

7. Abstandsschätzvorrichtung nach einem der Ansprüche 1 bis 6, wobei die Wärmebehandlung Erwärmungsbehandlung und/oder Kühlbehandlung ist.

8. Anomaliefeststellungsvorrichtung (6, 6a, 6b), welche aufweist:

   die Abstandsschätzungsvorrichtung (7, 7a, 7b) nach einem der Ansprüche 1 bis 7; und eine Feststellungsvorrichtung (8) zur Feststellung des Vorhandenseins oder Fehlens von Anomalie der Wärmebehandlung durch Vergleich eines von der Abstandsschätzvorrichtung abgeschätzten Abstands mit einer Schwelle.

9. Anomaliefeststellungsvorrichtung, welche aufweist:

   die Abstandsschätzvorrichtung nach Anspruch 7; und eine Feststellungsvorrichtung (8) zur Feststellung des Zustands des zu behandelnden Objekts beruhend auf den von der Abstandsschätzvorrichtung abgeschätzten Abständen zwischen einer Anzahl von Punkten, wobei Anomalie beruhend auf der Ausgabe der Feststellungsvorrichtung festgestellt wird.

10. Temperaturregler (2, 2a, 2b), welcher die Abstandsschätzvorrichtung nach einem der Ansprüche 1 bis 7 aufweist, wobei die Temperatur der Wärmebehandlungsvorrichtung geregelt wird.

11. Temperaturregler nach Anspruch 10 zur Regelung der Temperatur der Wärmebehandlungsvorrichtung so, dass eine von der Temperaturfeststellungsvorrichtung zur Feststellung der Temperatur der Wärmebehandlungsvorrichtung festgestellte Temperatur gleich einer Solltemperatur ist, wobei dieser ferner eine Korrekturvorrichtung (23) zur Korrektur der Solltemperatur und/oder der festgestellten Temperatur beruhend auf dem mit der Abstandsschätzvorrichtung abgeschätzten Abstand aufweist.

12. Temperaturregler nach Anspruch 10 oder 11, welcher ferner die Anomaliefeststellungsvorrichtung gemäß Anspruch 8 oder 9 aufweist, wobei die Temperatur der Wärmebehandlungsvorrichtung geregelt wird.

13. Wärmebehandlungsvorrichtung, welche aufweist: den Temperaturregler (2) nach einem der Ansprüche 10 bis 12; die Wärmebehandlungsvorrichtung (1); eine Betreibvorrichtung zum Heizen und/oder Kühlen der Wärmebehandlungsvorrichtung beruhend auf der Ausgabe des Temperaturreglers; und eine Temperaturfeststellungsvorrichtung zur Feststellung der Temperatur der Wärmebehandlungsvorrichtung.

**Revendications**

1. Appareil d'estimation de distance (7) pour estimer une distance (d) entre un objet (4) à traiter et un dispositif de traitement thermique (1) lors d'un traitement thermique réalisé en amenant l'objet (4) à traiter à proximité du dispositif de traitement thermique (1), comprenant : un dispositif d'estimation de distance (7) pour estimer la distance (d) en fonction d'une information concernant une température d'au moins l'un parmi l'objet (4) à traiter ou le dispositif de traitement thermique (1), dans lequel l'information de température comprend une information concernant un changement de différence de température entre le dispositif de traitement thermique (1) et l'objet (4) à traiter après que l'objet (4) à traiter a été amené à proximité du dispositif de traitement thermique (1) et plus le changement de différence de température est important, plus le dispositif d'estimation de distance (7) estime que la distance (d) est petite.

2. Appareil d'estimation de distance selon la revendication 1, dans lequel le dispositif d'estimation de distance (7a) s'adapte pour entrer une quantité de fonctionnement d'un dispositif de contrôle de température (3) et estime la distance en fonction d'une information concernant la quantité de fonctionnement du dispositif de contrôle de température pour contrôler la température du dispositif de traitement thermique en plus d'au moins chaque partie de l'information de température, dans lequel l'information de quantité de fonctionnement est une information concernant la quantité de fonctionnement du dispositif de contrôle de température (3) après que l'objet à traiter a été amené à proximité du dispositif de traitement thermique, et plus la quantité de fonctionnement est importante, plus le dispositif d'estimation de distance estime que la distance est petite.

3. Appareil d'estimation de distance selon la revendication 2, le dispositif d'estimation de distance (7b) comprenait en outre : une première partie d'estimation (17) pour estimer la résistance thermique entre un objet à traiter et un dispositif de traitement thermique ; et une second partie d'estimation (18) pour estimer la distance en fonction de la résistance thermique estimée.

4. Appareil d'estimation de distance selon l'une quelconque des revendications 1 à 3, dans lequel chaque partie de l'information destinée à être utilisée dans l'estimation de la distance est l'information pendant une partie d'une période lorsque la température du dispositif de traitement thermique revient à une température constant, après que l'objet à traiter a été amené à proximité du dispositif de traitement thermique.

5. Appareil d'estimation de distance selon l'une quelconque des revendications 1 à 4, dans lequel le dispositif de traitement thermique est une plaque chaude (1) par rapport à laquelle l'objet à traiter est placé et ensuite traité thermiquement.

6. Appareil d'estimation de distance selon l'une quelconque des revendications 1 à 5, dans lequel le dispositif d'estimation de distance estime des distances respectives entre une pluralité de points du dispositif de traitement thermique et une pluralité de points correspondants de l'objet à traiter.

7. Appareil d'estimation de distance selon l'une quelconque des revendications 1 à 6, dans lequel le traitement thermique est au moins l'un parmi un traitement chauffant ou un traitement de refroidissement.

8. Appareil de détection d'anomalie (6, 6a, 6b) comprenant : l'appareil d'estimation de distance (7, 7a, 7b) selon l'une quelconque des revendications 1 à 7 ; et un dispositif de détermination (8) pour déterminer une présence ou une absence d'anomalie du traitement thermique en comparant une distance estimée par l'appareil d'estimation de distance et un seuil.

9. Appareil de détection d'anomalie comprenant : l'appareil d'estimation de distance selon la revendication 7 ; et un dispositif de détermination (8) pour déterminer l'état de l'objet à traiter en fonction des distances entre une pluralité de points qui sont estimés par l'appareil d'estimation de distance, dans lequel l'anomalie est détectée en fonction du résultat du dispositif de détermination.

10. Régulateur de température (2, 2a, 2b) comprenant l'appareil d'estimation de distance selon l'une quelconque des revendications 1 à 7, dans lequel une température du dispositif de traitement thermique est contrôlée.

11. Régulateur de température selon la revendication 10 pour contrôler la température du dispositif de traitement thermique de sorte qu'une température détectée par un dispositif de détection de température pour détecter une température du dispositif de traitement thermique est égale à une température déterminée, comprenant en outre un dispositif de correction (23) pour corriger au moins l'une parmi la température déterminée ou la température détectée en fonction de la distance estimée par l'appareil d'estimation de distance.

12. Régulateur de température selon la revendication 10 ou 11, comprenant en outre l'appareil de détection d'anomalie selon la revendication 8 ou 9, dans lequel la température du dispositif de traitement thermique est contrôlée.

13. Appareil de traitement thermique comprenant : le régulateur de température (2) selon l'une quelconque des revendications 10 à 12 ; le dispositif de traitement thermique (1) ; un dispositif de commande pour chauffer et/ou refroidir le dispositif de traitement thermique en fonction du résultat du régulateur de température ; et un dispositif de détection de température pour détecter la température du dispositif de traitement thermique.

Fig. 1

Fig. 2

Fig. 3A

Fig. 3B

Fig. 4

Fig. 5

Fig. 6

Sp

PID controller — 3

U

Hot plate — 1

PV

Distance estimation — 7a

Determination — 8

Timing signal

2a

6a

EP 1 712 877 B1

19

Fig. 7A

Fig. 7B

4

d

9

1

Electric power W

4

Cw

Tw

Rhw

Ch

Th

Electric
power W

9

Fig. 8

Distance: 1 mm
Distance: 4 mm

Estimated distance (mm)

10

8

6

4

2

0

20          40          60

Time (second)

Fig. 9

Fig. 10

P V

13

12'

$1/\theta'$  +  ○  −

20

$A_{22}'$  11'

Fig. 11

7c  21  22

Temperature
Operational → Distance → Shape → Determina- →
amount      estimation   recognition   tion

Fig. 12

7c  23

Temperature
Operational → Distance → SP correction
amount      estimation   part

ΔSP

Corrected SP

SP →  ○  →

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004134723 A
- AT 406423 B
- JP 2004094939 A
- JP 2003289867 A